# EUROPEAN PATENT APPLICATION

(11) **EP 1 335 493 A1**
(43) Date of publication of application: **13.08.2003**
(21) Application number: 02075526.0
(22) Date of filing: 07.02.2002
(51) Int. Cl.: H03K 19/003, H03K 17/16, H03M 1/08

(54) **Reduction of sensitivity for spikes in integrated circuits**

(71) Applicant: Koninklijke Philips Electronics N.V., 5621 BA Eindhoven (NL)
(72) Inventor: Buethker, Henrikus Cornelis Johannes, Prof. Holstlaan 6, 5656 AA Eindhoven (NL)
(74) Representative: Steenbeek, Leonardus Johannes

(57) **Abstract**

A method and apparatus for disabling or blanking the control circuit (112) of an integrated circuit (100) during voltage spikes which occur during switching transitions is disclosed. The occurrences of switching transitions are first calculated. The inputs (118, 120) of the control circuit (112) are then disabled (154, 156) during the switching transition. Alternatively, the outputs of the voltage comparators of an A/D converter in the control circuit can be latched during the switching transitions.

## Description

### Field of the Invention

The invention relates generally to integrated circuits, and more particularly to reducing the disturbance caused by voltage spikes to control circuits in integrated circuits during switching transitions.

### Background of the Invention

Integrated circuits (ICs) are well known in the art. ICs include literally hundreds of thousands, even millions of transistors which are logically coupled to one another to provide arithmetic and logic units, address decoders, memory, control registers, and the like. While computational ability and logical processing provided by such ICs can be extraordinary, the capabilities of these ICs are of little value unless the IC is coupled to receive inputs from an external device and provides outputs to an external device. The electrical connection between the internal transistors provided on the semiconductor substrate inside an IC and the circuit traces provided on the printed circuit card or the like is usually achieved through a conductive pin mounted to the housing for the IC. One end of the conductive pin extends outwardly from the housing so it may be soldered or otherwise connected to the circuit trace on a printed circuit card. The other end of the conductive pin extends inside the housing and is coupled to an I/O pad on the substrate through conductive elements, which are bonded at one end to the pin and at the other end to the I/O pad.

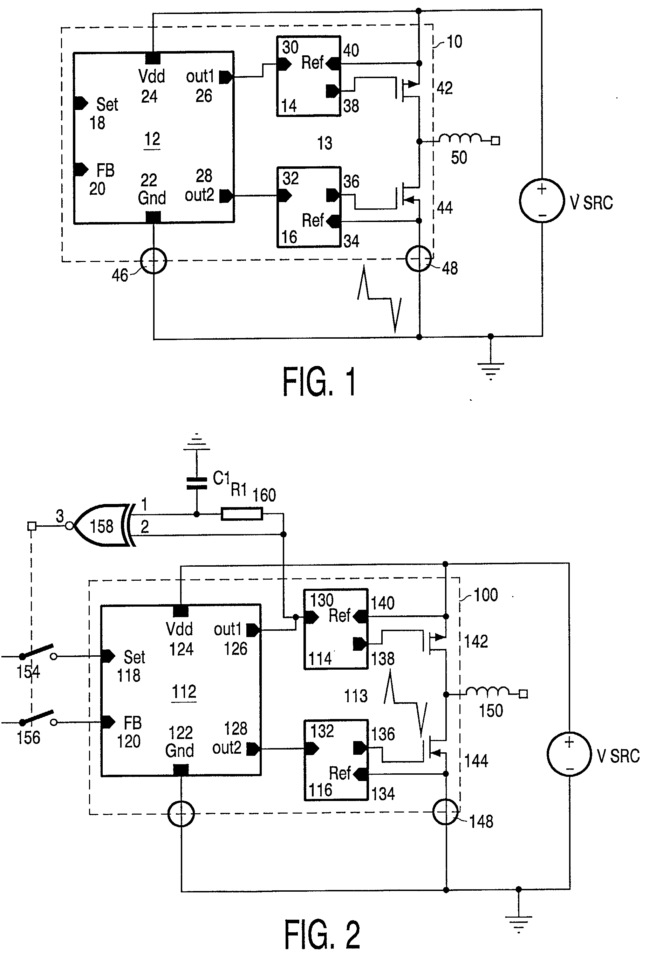

In present ICs, a control circuit 12 and a power section 13 are integrated in one IC 10 as illustrated in Fig. 1. The control circuit 12 has a plurality of inputs 18, 20 and a plurality of outputs 26, 28. In addition, the control circuit 12 is connected to Vdd 24 and ground 22. The power section 13 comprises a plurality of driver circuits 14, 16 and a plurality of power transistors 42, 44. Each output 26, 28 of the control section 12 is connected to a driver 14, 16, via inputs 30, 32, respectively. The power transistors 42, 44 are connected to an output 38, 40 of each driver 14, 16, respectively. In addition, a return line 40, 34 is connected to each driver 14, 16, respectively. An inductor 50 is connected to the power transistors 42, 44. The power transistors 42, 44 are periodically turned on and off by the drivers 14, 16 as controlled by control circuit 12. In essence, the power transistors act as switches which are opened and closed by the input signals supplied by to the driver circuits 14, 16. In this example, the control circuit 12 has a control ground pin 46 and the power section has a power ground pin 48.

The switching of the power transistors 42, 44 generates a high dI/dt in the power pins. Because of the inductance of the pins and the copper traces, a voltage spike will occur. This spike can disturb the control circuit 12 because the voltage spike can raise the ground voltage level. Using separate power and control pins usually eliminates this problem. However, the use of separate pins results in a more complicated layout and a degradation in performance. In addition, if there still is a coupling between the power ground and the control ground, noise may still enter the control circuit 12.

Thus, there is a need in the art for a method and apparatus for insulating the control circuit in an IC from these voltage spikes that occur when switching power transistors.

### Summary of the Invention

It is an object of the invention to overcome the above-described deficiencies of the prior art. The invention is defined by the independent claims. The dependent claims define advantageous embodiments. According to an advantageous aspect of the invention, the object is achieved by freezing the state of the control circuit during the spikes by holding all voltages and currents constant during each spike.

These and other aspects of the invention will be apparent from and elucidated with reference to the embodiments described hereafter.

### Brief Description of the Drawings

The invention will now be described, by way of example, with reference to the accompanying drawings, wherein:
Fig. 1 is a block diagram of a known integrated circuit with a control circuit and a power section;
Fig. 2 is a block diagram of an integrated circuit according to one embodiment of the invention;
Fig. 3 is a block diagram of an integrated circuit according to another embodiment of the invention;
Fig. 4 is a block diagram of an integrated circuit according to another embodiment of the invention; and
Fig. 5 is a block diagram of a transmission gate according to one embodiment of the invention.

### Detailed Description of the Invention

The voltage spikes caused by the switching transitions are generated by the integrated circuit. Thus, the occurrence of the spikes can be predicted and calculated by the integrated circuit. According to one embodiment of the invention, all of the voltages and currents in the control circuit are kept constant during each spike. All of the capacitors in the control circuit that can be influenced by ground spikes are isolated by a series switch. All current mirrors are decoupled from the inputs, e.g., by sampling circuits.

Fig. 2 illustrates an integrated circuit according to one embodiment of the invention. The integrated circuit 100 has a control circuit 112 and a power section 113. The control circuit 112 has a plurality of inputs 118, 120 and a plurality of outputs 126, 128. In addition, the control circuit 112 is connected to Vdd 124 and ground 122. The power output section 113 comprises a plurality of driver circuits 114, 116 and a plurality of power transistors 142, 144. Each output 126, 128 of the control section 112 is connected to a driver 114, 116, via inputs 130, 132, respectively. The power transistors 142, 144 are connected to an output 138, 136 of each driver 114, 116, respectively. In addition, a return line 140, 134 is connected to each driver 114, 116, respectively. An inductor 150 is connected to the power transistors 142, 144. The power transistors 142, 144 is periodically turned on and off by the drivers 114, 116 as controlled by control circuit 112. When the power transistors 142, 144 are turned on and off, voltage spikes occur raising the ground voltage level.

The voltage spike on the power ground pin 148 can be seen as a common mode disturbance on all other inputs of the control circuit 112. According to one embodiment of the invention, all inputs of the control block are disabled during a switching transition of the power transistors 142, 144. This works particularly well for high-impedance inputs and most feedback and control inputs are high-impedance. As illustrated in Fig. 2, switches 154 and 156 have been added to the input lines 118, 120 of the control circuit 112 to disable each input of the control circuit 112. The switches 154, 156 disable the inputs 118, 120 of the control circuit 112 by opening during transitions of the power transistors 142, 144. The opening and closing of the switches 142, 144 can be accomplished using an exclusive OR unit 158 and a small delay provided by a resistor 160. In this example, one input signal to the exclusive OR unit 158 is the output signal from the control circuit 112 to the driver circuit 114. The second input signal to the exclusive OR unit 158 is the output signal from the control circuit 112 to the driver circuit 114 which has been delayed by the resistor 160. However, it will be understood by those skilled in the art that there are many possible ways of obtaining a suitable driving signal to open and close the switches 154, 156, including a digital driving circuit and the invention is not limited thereto. During the transition of the output state, the input signals of the exclusive OR unit 158 are not equal and the output generates a pulse that can be used to open the switches 154, 156, thereby disabling the inputs of the control circuit 112 during the switching transition.

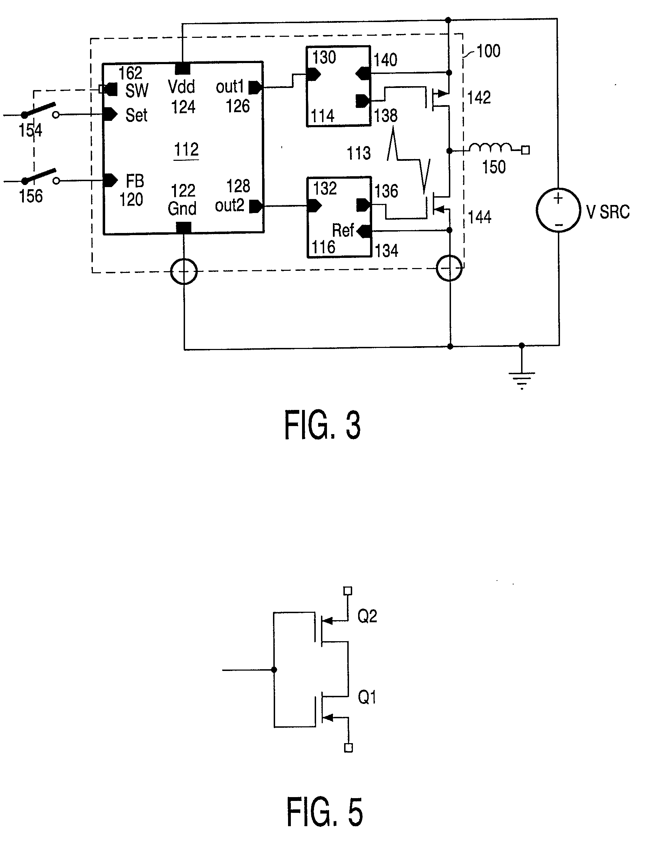

It will be understood by those skilled in the art that the switches 154, 156 can be controlled by other means to disable the inputs of the control circuit 112 during the switching transition. For example, the switches 154, 156 can be controlled by signals generated from the control circuit, as illustrated in Fig. 3. As noted above, the voltage spikes are generated by the integrated circuit 100. In this embodiment, the control circuit 112 calculates when the voltage spikes (switching transition) will occur and outputs a control signal 162 to the switches 154, 156 to disable the control circuit inputs during the switching transitions. After each switching transition a second control signal 162 can be sent to close the switches 154, 156 so as to allow normal operation.

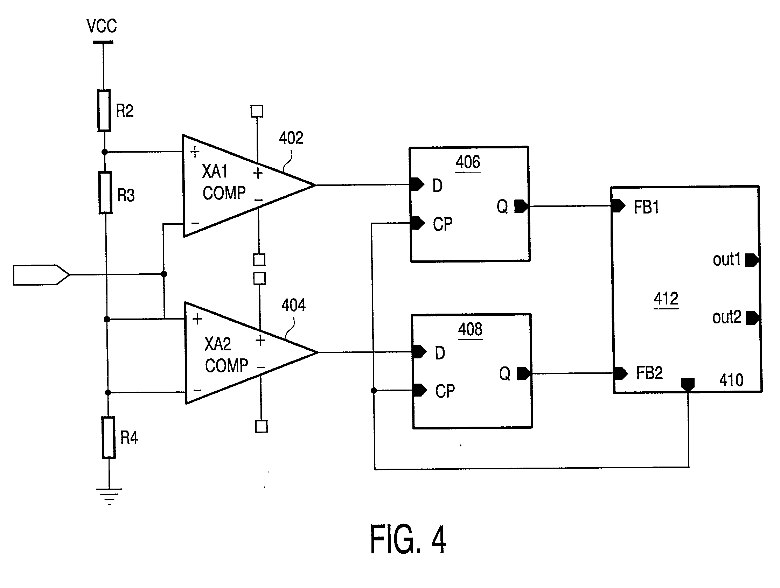

According to another embodiment of the invention, the state of the control parameters in the control circuit are frozen during the switching transition. By freezing the control parameters during the switching transitions, the control parameters will not be corrupted by the resulting voltage spikes. This embodiment of the invention works quite well if a digital control circuit is being used in the integrated circuit. A digital controller needs an A/D converter to measure the controlled signal. As illustrated in Fig. 4, the A/D converter is comprised of two voltage comparators 402, 404. In this embodiment of the invention, the control parameters can be frozen by latching the outputs of the voltage comparators during a switching transition using latch devices 406, 408. First, the digital control circuit 412 calculates when a switching transition will occur. The control circuit 412 can then latch the outputs of the voltage comparators 402, 404 during the switching transition by sending a latch signal 410 to the latch devices 406, 408. After each switching transition, the outputs of the voltage comparators 402, 404 are unlatched and regular operation resumes.

The switches 154, 156 can be realized by a pair of MOSFETs configured as a transmission gate as illustrated in Fig. 5. The MOSFETs Q1 and Q2 are controlled by the gate control input. It will be understood by those skilled in the art that the switches can be realized in a variety of ways and the invention is not limited thereto.

The above-described embodiments of the invention disable or blank the control circuit of an integrated circuit during voltage spikes which occur during switching transitions, thus insulating the control circuit from the effects of the voltage spikes. It should be noted that the above-mentioned embodiments illustrate rather than limit the invention, and that those skilled in the art will be able to design many alternative embodiments without departing from the scope of the appended claims. It will be understood that the different embodiments of the invention are not limited to the exact order of the above-described steps as the timing of some steps can be interchanged without affecting the overall operation of the invention. Furthermore, the term "comprising" does not exclude other elements or steps, the terms "a" and "an" do not exclude a plurality, and a single processor or other unit may fulfill the functions of several of the means, units or circuits recited in the claims. In the claims, any reference signs placed between parentheses shall not be construed as limiting the claim. The invention can be implemented by means of hardware comprising several distinct elements, and by means of a suitably programmed computer. The mere fact that certain measures are recited in mutually different dependent claims does not indicate that a combination of these measures cannot be used to advantage.

## Claims

1. An integrated circuit (100), comprising:
a control circuit (112);
power transistors (142, 144); and
an apparatus for disabling inputs (118, 120) of the control circuit (112) during a switching transition of the power transistors (142, 144), the apparatus comprising:
a plurality of switches (154, 156) coupled to respective inputs (118, 120) of the control circuit (112); and
means (158, 160) for opening said plurality of switches during the switching transition whereby the inputs (118, 120) of the control circuit (120) are disabled by opening the plurality of switches (154, 156).

2. The integrated circuit of claim 1, wherein the means (158, 160) for opening said plurality of switches include an output (126, 162) of the control circuit (112).

3. The integrated circuit of claim 2, wherein said means (158, 160) for opening the plurality of switches (154, 156) comprise an exclusive OR device (158) and a delay means (160), wherein a first input of the exclusive OR device (158) is an output signal (126) from the control circuit (112) and a second input of the exclusive OR device is the output signal (126) from the control circuit (112) delayed by the delay means (160).

4. The integrated circuit according to claim 3, wherein said delay means (160) are a resistor.

5. A method for preventing ground spikes from affecting a control circuit (112) on an integrated circuit (100) during a switching transition of power transistors (142, 144) in the integrated circuit, the method comprising:
calculating when the switching transition will occur; and
disabling inputs (118, 120) of the control circuit (112) during the switching transition.

6. The method according to claim 5, wherein each input (118, 120) of the control circuit (120) is disabled by opening a respective switch (154, 156) connected to the input (118, 120).

7. The method according to claim 6, wherein the control circuit (112) determines when the switching transition will occur.

8. The method according to claim 7, wherein the control circuit (112) generates control signals for opening and closing the plurality of switches (154, 156).

9. A method for freezing the state of control parameters in a digital control circuit, having an A/D converter comprised of two voltage comparators (402, 404), during a switching transition of power transistors on an integrated circuit, the method comprising the steps of:
calculating when the switching transition will occur; and
latching the outputs of the voltage comparators (402, 404) during the switching transition.

10. A digital control circuit in an integrated circuit for freezing the state of control parameters during a switching transition of power transistors in the integrated circuit, the digital control circuit comprising:
means for calculating when the switching transition will occur;
an A/D converter comprised of two voltage comparators (402, 404); and
latching means (406, 408) for latching the outputs of the voltage comparators during the switching transition.

11. The digital control circuit according to claim 10, wherein the digital control circuit (412) sends a latch signal to the latching means (406, 408) to control the latching of the outputs of the voltage comparators (402, 404).
